# EUROPÄISCHE PATENTANMELDUNG

(11) **EP 0 944 116 A2**
(43) Veröffentlichungstag der Anmeldung: **22.09.1999**
(21) Anmeldenummer: 98121017.2
(22) Anmeldetag: 05.11.1998
(51) Int. Cl.: H01L 29/786, H01L 23/29

(54) **Verfahren zur Herstellung von Dünnschichttransistoren aus Cadmium-Selenid**

(30) Priorität: 18.02.1998 DE 19806625
(71) Anmelder: Lüder, Ernst, Prof. Dr.-Ing. habil., D-70550 Stuttgart (DE)
(72) Erfinder: Lüder, Ernst, 70550 Stuttgart (DE); Frohna, Michael, 70186 Stuttgart (DE)
(74) Vertreter: Möbus, Daniela, Dr.-Ing.

(57) **Zusammenfassung**

Ein Verfahren zur Herstellung von Dünnschichttransistoren sowie ein Dünnschichttransistor mit einem Halbleiterkanal (13) aus Cadmium-Selenid und einer Passivierungsschicht (15) für den Halbleiterkanal, wobei die Passivierungsschicht (15) aus einem sauerstoffreien, elektrisch nichtleitenden Material besteht.

## Beschreibung

Die Erfindung betrifft ein Verfahren zur Herstellung von Dünnschichttransistoren, insbesondere zur Ansteuerung von Bildpunkten eines Flüssigkristallbildschirms und für den Einsatz in den dafür erforderlichen Treiberschaltungen, mit einem Halbleiterkanal aus Cadmium-Selenid und einer Passivierungsschicht für den Halbleiterkanal.

Dünnfilmtransistoren mit einem Halbleiterkanal aus Cadmium-Selenid eignen sich insbesondere zur Verwendung für großflachige Flüssigkristallbildschirme und für Flüssigkristallbildschirme mit hohen Bildpunktdichten mit integrierten Treiberschaltungen. Sie sind in der Lage, die hohen Anforderungen, die diese Anwendung mit sich bringt, zu erfüllen und sind dennoch preisgünstig in der Herstellung. Dies liegt vor allem daran, daß die maximale Prozeßtemperatur während der Herstellung der Dünnschichttransistoren unter 400° C liegen kann. Cadmium-Selenid-Dünnschichttransistoren zeichnen sich außerdem durch eine sehr hohe Beweglichkeit der Ladungsträger von über 200 cm²/Vs und Sperrströmen von weniger als 10⁻¹³ A aus. Da diese Eigenschaften von Cadmium-Selenid-Dünnschichttransistoren nur eine geringe Langzeitstabilität aufweisen, wird zumindest der empfindliche Halbleiterkanal zum Schutz vor äußeren Einflüssen mit einer Passivierungsschicht abgedeckt. Bislang werden als Passivierungsmaterialien Oxide wie SiO₂ oder Al₂O₃ verwendet. Diese Materialien haben jedoch einen negativen Einfluß auf die elektrischen Eigenschaften des Transistors. So nimmt die Beweglichkeit ab, der Sperrstrom zu, und das Schaltverhältnis sinkt. Außerdem ist die Reproduzierbarkeit im Sinne der Homogenität der Eigenschaften der Dünnschichttransistoren auf einem Substrat nicht gewährleistet. Auch die erwünschte Langzeitstabilität der Transistoren kann mit diesen Passivierungsmaterialien nicht garantiert werden.

Zur Abhilfe dieses Problems schlägt die vorliegende Erfindung ein Verfahren zur Herstellung von Dünnschichttransistoren der eingangs genannten Art vor, das erfindungsgemäß dadurch gekennzeichnet ist, daß mindestens über dem Halbleiterkanal ein sauerstoffreies, elektrisch nicht leitendes Material als Passivierungsschicht aufgebracht wird. Vorzugsweise kann die Passivierungsschicht jedoch ganzflächig über den Transistor aufgebracht werden. Versuche haben gezeigt, daS ein sauerstoffreies Material als Grenzschicht zwischen dem Halbleiter und Luft die Eigenschaften der Dünnschichttransistoren auch über einen längeren Zeitraum hin nicht verschlechtert. Dies ist darauf zurückzuführen, daß keine reaktiven Sauerstoffanteile die Korngrenzen des polykristallinen Cadmium-Selenid-Materials, die einen wesentlichen Einfluß auf die Schalteigenschaften des Transistors haben, negativ beeinflussen können. Es läßt sich außerdem eine weitere Passivierungsschicht auf die sauerstoffreie Passivierungsschicht aufbringen, die auch Sauerstoff enthalten darf, um die Schutzeigenschaften der Passivierung insgesamt zu erhöhen. Diese zweite Passivierungsschicht kann die Eigenschaften des Dünnschichttransistors aufgrund der zuvor aufgebrachten sauerstoffreien Passivierungsschicht kaum mehr verändern.

Die Erfindung betrifft außerdem einen Dünnschichttransistor, insbesondere zur Ansteuerung von Bildpunkten eines Flüssigkristallbildschirms und für den Einsatz in den dafür erforderlichen Treiberschaltungen, mit einem Halbleiterkanal aus Cadmium-Selenid, der gekennzeichnet ist durch eine mindestens über dem Halbleiterkanal aufgebrachte sauerstoffreie, elektrisch nichtleitende Passivierungsschicht. Dieser Dünnschichttransistor weist Eigenschaften auf, die vergleichbar oder sogar noch besser sind als diejenigen eines Dünnschichttransistors ohne Passivierungsschicht. Die erreichte Langzeitstabilität durch diese Passivierungsschicht ist als sehr gut zu bezeichnen. Der Transistor kann außerdem eine zweite Passivierungsschicht aus einem Material mit oder ohne Sauerstoff aufweisen, wobei beide Passivierungsschichten vorzugsweise ganzflächig über dem Transistor aufgebracht sein können.

Nachfolgend wird eine bevorzugte Ausgestaltung des erfindungsgemäßen Verfahrens zur Herstellung eines Dünnschichttransistors mit Cadmium-Selenid als Halbleiter anhand der Zeichnung näher beschrieben.

Es zeigen:
- Fig. 1: einen Querschnitt durch einen Dünnschichttransistor in einem ersten Herstellungsstadium;
- Fig. 2: einen Querschnitt durch den Transistor aus Fig. 1 in einem zweiten Herstellungsstadium;
- Fig. 3: einen Querschnitt durch den Transistor aus Fig. 1 in einem dritten Herstellungsstadium.

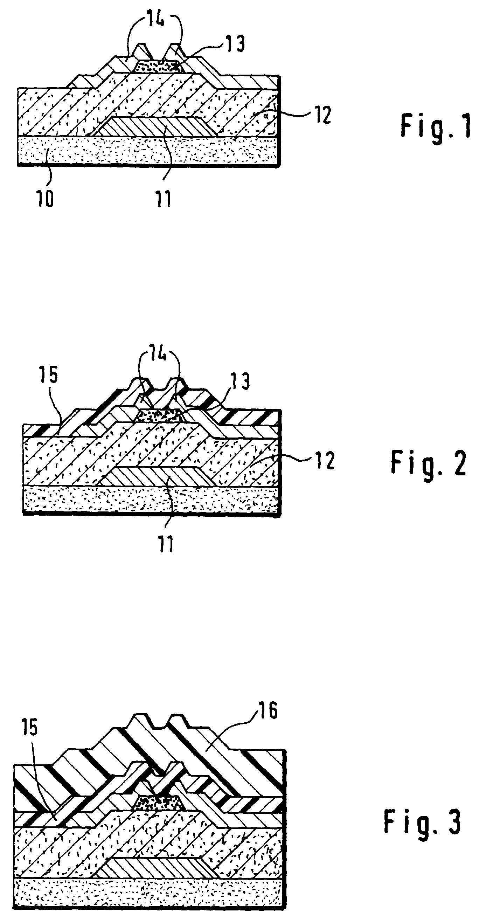

Fig. 1 zeigt ein Substrat 10, auf das eine erste Metallschicht 11 aufgebracht und zu einem Gate-Anschluß strukturiert wurde. Darüber wurde ein Gate-Dielektrikum 12 abgeschieden, das üblicherweise aus SiO₂ besteht. Im nächsten Schritt wurde Cadmium-Selenid, beispielsweise durch Aufdampfen oder durch einen Sputterprozeß, aufgebracht und der Halbleiterkanal 13 strukturiert. Aus einer darüber aufgebrachten weiteren Metallschicht wurden die Drain- und Source-Kontakte 14 gebildet. In dem in Fig. 1 gezeigten Zustand weist der Dünnschichttransistor sehr gute Eigenschaften hinsichtlich der Beweglichkeit der Ladungsträger und der Sperrströme sowie des Schaltverhältnisses auf. Diese Eigenschaften sind jedoch nicht langzeitstabil. Deshalb wird in dem in Fig. 2 gezeigten Verfahrensschritt eine relativ dünne Passivierungsschicht 15 aus einem sauerstoffreien, nichtleitenden Material aufgebracht. Jetzt ist der empfindliche Halbleiterkanal 13 vor Umwelteinflüssen wie Feuchtigkeit und Sauerstoff geschützt. Die sehr guten Eigenschaften des Transistors im in Fig. 1 dargestellten Herstellungsstadium bleiben erhalten oder werden sogar noch verbessert. Eine Verbesserung der Eigenschaften läßt sich insbesondere auch durch eine Vakuumtemperung des Transistors mit oder ohne Gasatmosphäre nach Aufbringen der Schicht 15 erreichen. Anschließend kann, wie in Fig. 3 gezeigt ist, eine weitere, dicke Passvierungsschicht 16 aufgebracht werden, die auch Sauerstoff enthalten darf. Diese Schicht 16 verbessert die Schutzeigenschaft der Passivierung, ohne dabei die Eigenschaften des Dünnfilmtransistors aufgrund der zwischen ihr und dem Halbleiterkanal 13 liegenden ersten Passivierungsschicht 15 verschlechtern zu können. Der Transistor im in Fig. 3 gezeigten Herstellungsstadium ist von seiner Charakteristik her vergleichbar mit dem Transistor im Zustand nach Fig. 1, meist jedoch noch besser. Die Reproduzierbarkeit der Eigenschaften der Transistoren auf einem Substrat wird wesentlich verbessert. Außerdem zeigt der Transistor gemäß Fig. 3 eine sehr gute Langzeitstabilität.

## Patentansprüche

1. Verfahren zur Herstellung von Dünnschichttransistoren, insbesondere zur Ansteuerung von Bildpunkten eines Flüssigkristallbildschirms und für den Einsatz in den dafür erforderlichen Treiberschaltungen, mit einem Halbleiterkanal (13) aus Cadmium-Selenid und einer Passivierungsschicht (15, 16) für den Halbleiterkanal, dadurch gekennzeichnet, daß mindestens über dem Halbleiterkanal (13) ein sauerstoffreies, elektrisch nichtleitendes Material (15) als Passivierungsschicht (15, 16) aufgebracht wird.

2. Verfahren nach Anspruch 1, dadurch gekennzeichnet, daß die Passivierungsschicht (15) ganzflächig über dem Transistor aufgebracht wird.

3. Verfahren nach Anspruch 1 oder 2, dadurch gekennzeichnet, daß eine weitere, sauerstoffreie oder sauerstoffhaltige Passivierungsschicht (16) auf die erste Passivierungsschicht (15) aufgebracht wird.

4. Dünnschichttransistor, insbesondere zur Ansteuerung von Bildpunkten eines Flüssigkristallbildschirms und für den Einsatz in den dafür erforderlichen Treiberschaltungen, mit einem Halbleiterkanal (13) aus Cadmium-Selenid, gekennzeichnet durch eine mindestens über dem Halbleiterkanal (13) aufgebrachte sauerstoffreie, elektrisch nichtleitende Passivierungsschicht (15).

5. Dünnschichttransistor nach Anspruch 4, dadurch gekennzeichnet, daß über der ersten Passivierungsschicht (15) eine zweite Passivierungsschicht (16) aus einem sauerstoffreien oder sauerstoffhaltigen Material aufgebracht ist.

6. Dünnschichttransistor nach Anspruch 4 oder 5, dadurch gekennzeichnet, daß die Passivierungsschichten (15, 16) ganzflächig auf dem Transistor aufgebracht sind.
